# EUROPEAN PATENT APPLICATION

(11) **EP 1 811 050 A2**
(43) Date of publication of application: **25.07.2007**
(21) Application number: 06251839.4
(22) Date of filing: 31.03.2006
(51) Int. Cl.: C22C 19/07, C23C 14/34

(54) **Magnetic sputter targets manufactured using directional solidification**

(30) Priority: 23.01.2006 US 336980
(71) Applicant: Heraeus, Inc., Chandler AZ 85226 (US)
(72) Inventor: Kunkel, Bernd, Phoenix, AZ 85048 (US); Long, David, Chandler, AZ 85249 (US); Ziani, Abdelouahab, chandler, AZ 85226 (US); Das, Anirban, Tempe, AZ 85283 (US); Hui, Jun, Maricopa, AZ 85239 (US)
(74) Representative: Hill, Justin John

(57) **Abstract**

A sputter target includes a metal alloy having a target surface, a rear surface and a thickness between the target and rear surfaces. The target surface and rear surface are outer surfaces of the metal alloy. The metal alloy has a thickness direction substantially along the thickness. The target surface is substantially normal to the thickness direction. The metal alloy has a single substantially homogenous microstructural zone across substantially the entire thickness. The metal alloy further includes dendrites. The dendrites at the target surface are oriented along substantially one direction, and the dendrites at a center plane of the metal alloy are oriented along substantially the same one direction. A sputter target may include a metal alloy which is a cobalt (Co) based, and may have a [0001] hexagonal close-packing (HCP) direction oriented substantially normal to the target surface. The sputter target may be formed by directional solidification at near-equilibrium temperature conditions by withdrawing the metal alloy at a first rate through a temperature gradient. The sputter target is for forming one or more magnetic layers on a substrate for, among other purposes, data storage.

## Description

### FIELD OF THE INVENTION

The present invention generally relates to sputter targets and, in particular, relates to sputter targets with improved microstructural homogeneity and pass through flux ("PTF"), and to the products produced therefrom such as thin film magnetic media.

### BACKGROUND OF THE INVENTION

Cathodic sputtering processes are widely used for the deposition of thin films of material onto desired substrates. In particular, thin film magnetic media can be manufactured using a cathodic sputtering process. Concomitant with the ever increasing demand for improved magnetic storage media has been an increasing need for thin films of magnetic media with improved magnetic characteristics and uniformity. To obtain thin films with these desired attributes, it is necessary to use sputter targets with improved microstructural homogeneity.

One approach to improving the microstructural homogeneity of sputter targets is a process using vacuum induction melting and ingot solidification, followed by thermo-mechanical working. These techniques are limited in effectiveness due to the increased manufacturing time required by thermo-mechanical working processes, such as rolling and heat treatment. Moreover, these processes may significantly limit the yield of sputter targets composed of low-ductility alloys, as the risk of ingot cracking during the thermo-mechanical working is higher with these difficult-to-roll alloys. Further, any deviation from the rolling and heat treatment process window can result in un-precedent microstructural non-homogeneity across the target thickness (*e.g*., along the sputter direction).

Additionally, for adequate material removal and deposition during the cathodic sputtering process, the PTF of the applied magnetic field through the sputter target is critical. A lower PTF necessitates a higher voltage/power compensation to sputter the target and hence limit its maximum utilization. The techniques to improve PTF made by standard solidification practices followed by thermo-mechanical working discussed above suffer from drawbacks of high expense, long processing time, and low yield.

What is needed is a sputter target with improves microstructural homogeneity and PTF. The present invention satisfies this need and provides other advantages.

### SUMMARY OF THE INVENTION

In accordance with the present invention, a sputter target is provided that has improved microstructural homogeneity and higher PTF than was previously possible. The sputter target is formed by directionally solidifying a metal alloy at near-equilibrium temperature conditions by withdrawing the metal alloy at a first rate through a temperature gradient. A sputter target thus manufactured has a single substantially homogenous microstructural zone substantially across its entire thickness.

According to one embodiment, the present invention is a sputter target including a metal alloy. The metal alloy has a target surface, a rear surface and a thickness between the target surface and the rear surface. The target surface and rear surface are outer surfaces of the metal alloy. The metal alloy has a single substantially homogenous microstructural zone across substantially the entire thickness.

According to another embodiment, a sputter target of the present invention includes a metal alloy having a target surface, a rear surface and a thickness between the target surface and the rear surface. The target surface and rear surface are outer surfaces of the metal alloy. The metal alloy has dendrites. The dendrites at the target surface are oriented along substantially one direction, and the dendrites at a center plane of the metal alloy are oriented along substantially the same one direction.

According to another embodiment, a sputter target of the present invention includes a metal alloy which is a cobalt (Co) based alloy. The metal alloy has a target surface, a rear surface and a thickness between the target surface and the rear surface. The target surface and rear surface are outer surfaces of the metal alloy. The target surface is substantially normal to the thickness direction. A [0001] hexagonal close-packing (HCP) direction of the metal alloy is oriented substantially normal to the target surface.

Additional features and advantages of the invention will be set forth in the description below, and in part will be apparent from the description, or may be learned by practice of the invention. The objectives and other advantages of the invention will be realized and attained by the structure particularly pointed out in the written description and claims hereof as well as the appended drawings.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide further understanding of the invention and are incorporated in and constitute a part of this specification, illustrate embodiments of the invention and together with the description serve to explain the principles of the invention. In the drawings:

Figure 1 depicts a sputter target according to one embodiment of the present invention;

Figure 2 depicts a partial view of a target surface of a sputter target according to one aspect of the present invention;

Figure 3 depicts a partial cross-sectional view of a sputter target according to another aspect of the present invention;

Figure 4 depicts a partial view of a target surface of a sputter target according to yet another aspect of the present invention;

Figure 5 depicts a partial view of a center plane of a sputter target according to yet another aspect of the present invention;

Figure 6 illustrates a directionally-solidified metal alloy according to yet another aspect of the present invention;

Figure 7 illustrates a partial view of a target surface of a sputter target;

Figure 8 illustrates a partial view of a center plane of a sputter target; and

Figure 9 depicts a sputter target according to another embodiment of the present invention.

### DETAILED DESCRIPTION OF THE INVENTION

In the following detailed description, numerous specific details are set forth to provide a full understanding of the present invention. It will be obvious, however, to one ordinarily skilled in the art that the present invention may be practiced without some of these specific details. In other instances, well-known structures and techniques have not been shown in detail not to obscure the present invention.

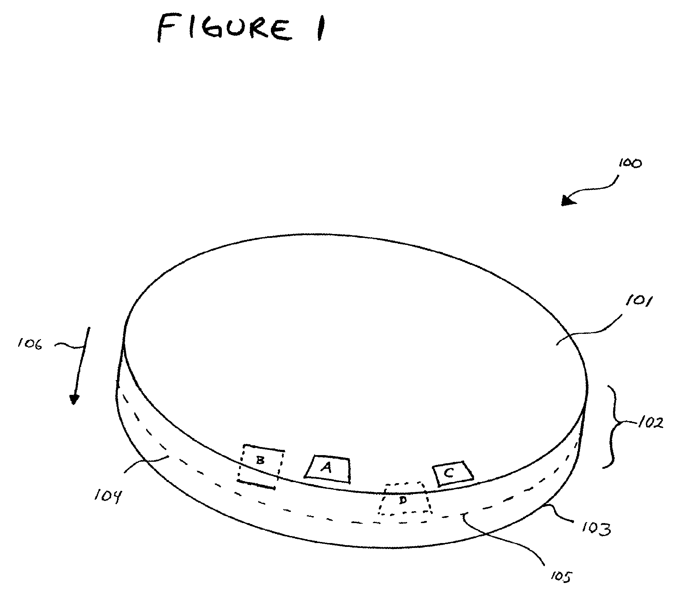

Referring to Figure 1, a sputter target in accordance with one embodiment of the present invention is illustrated. A sputter target 100 includes a metal alloy. The metal alloy has a target surface such as a target surface 101, a rear surface such as a rear surface 103, and a side surface such as a side surface 104. The metal alloy further has a thickness such as thickness 102 between target surface 101 and rear surface 103, and further has a thickness direction 106 substantially along the thickness 102. Target surface 101 is an outer surface of the metal alloy and is substantially normal to thickness direction 106. Side surface 104 is also an outer surface of the metal alloy. Rear surface 103 is an outer surface of the metal alloy and is substantially normal to thickness direction 106 or substantially parallel to target surface 101. According to one embodiment of the present invention, the metal alloy has a single substantially homogenous microstructural zone across substantially the entire thickness 102, as described more fully below. According to another embodiment of the present invention, a sputter target such as sputter target 100 may further include a center plane such as a center plane 105, disposed between target surface 101 and rear surface 103. In the present exemplary embodiment of Figure 1, the metal alloy of sputter target 100 is Co-5Ta-5Zr.

Directional solidification is a solidification process that enables solidification structures (*e.g.*, the dendrites) to preferentially grow and stabilize along specific orientations (*e.g*., the growth or solidification direction) homogenously across the entire melt. During directional solidification, a crucible such as, for example, a ceramic investment mold, containing the melt (*e.g.*, the molten metal or metal alloy to be solidified) is pulled at a specific withdrawal rate through a furnace or induction heating device in which a controllable, uniform thermal gradient is maintained across the entire melt during its directional solidification. When solidification occurs at a near-equilibrium temperature condition, the microstructural features are preferentially oriented along the solidification direction (*i.e.*, the direction opposite to the withdrawal direction). Directionality or anisotropy in microstructural appearance as well as crystallographic orientation can significantly lead to performance anisotropy with respect to both structural and functional properties (*viz.* magnetic).

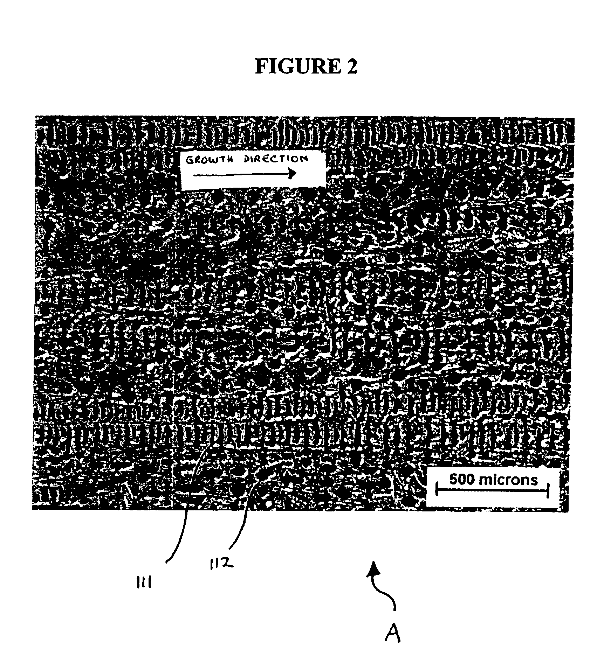

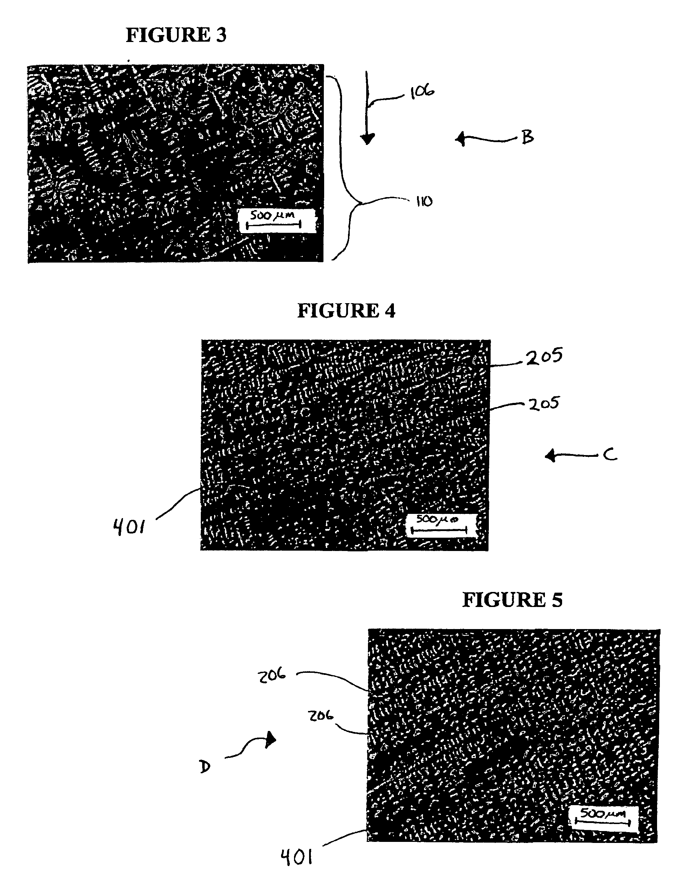

This preferential orientation is illustrated in Figure 2, which depicts a close-up view of region A of target surface 101 of sputter target 100 of Figure 1, in which microstructural features such as microstructural features 111 and 112 of target surface 101 can be seen. Figure 2 shows a typical microstructure of the directionally solidified Co-5Ta-5Zr alloy. A typical biphasic microstructure is observed, with the brighter phase constituting Co, Ta and Zr, whereas the darker phase predominantly constitutes Co and Ta. The dendritic phase is preferentially oriented along the growth direction. As a result of this preferential orientation of the microstructural features, the evolved solidification microstructure is substantially homogenous across the solidification direction (*i.e.,* the growth direction). Due to the uniform thermal gradient experienced by the entire melt during the directional solidification process, the microstructural features with respect to the shape and size of the solidified dendritic phase are observed to be substantially identical or similar both at the target surface 101 of the metal alloy and at a center plane 105 of the metal alloy, indicating microstructural homogenization (*e.g.*, a single substantially homogenous microstructural zone) across substantially the entire thickness 102 of sputter target 100. Figure 3, which depicts a partial cross-sectional view of region B of sputter target 100, illustrates this substantially homogenous microstructural zone 110 along thickness direction 106. Uniformly oriented dendritic structures are observed across the target thickness.

The microstructural homogeneity of a sputter target improves the microstructural homogeneity of the coating created by sputtering the target. A sputter target of the present invention may be used for sputtering one or more magnetic layers on a substrate for data storage. Alternatively, a sputter target of the present invention may be used for sputtering conductive layers on semiconductor substrates, for sputtering optical thin films, or for nearly any other sputtering application.

Region C of target surface 101 and region D of center plane 105 of sputter target 100 of Figure 1 are illustrated in Figures 4 and 5, respectively. According to one embodiment, sputter target 100 may include dendrites, such as dendrites 205 and 206. Dendrites 205 at a target surface 101 are oriented along substantially one direction 401 (*e.g.,* the growth direction), and dendrites 206 at a center plane 105 of the metal alloy are oriented along substantially the same one direction 401 (*e.g*., the growth direction).

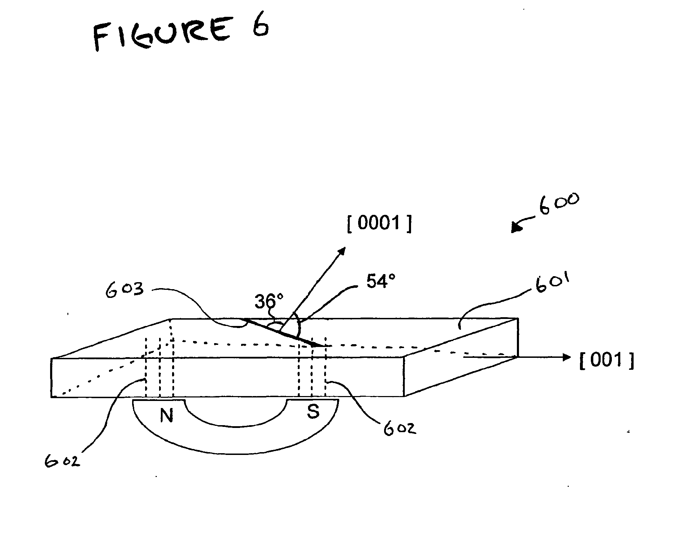

Turning now to Figure 6, a metal alloy 600 directionally solidified according to one aspect of the present invention is illustrated. According to one aspect of the present invention, metal alloy 600 may comprise two or more metals, including, by way of example and without limitation, two or more of cobalt (Co), iron (Fe), nickel (Ni), chromium (Cr), platinum (Pt), boron (B), copper (Cu), gold (Au), titanium (Ti), vanadium (V), yttrium (Y), zirconium (Zr), niobium (Nb), molybdenum (Mo), ruthenium (Ru), rhodium (Rh), lanthanum (La), hafnium (Hf), tantalum (Ta), tungsten (W), or iridium (Ir). According to another aspect of the present invention, metal alloy 600 may comprise one or more metals.

According to yet another embodiment, metal alloy 600 may include a broad range of low moment (Cr content > 18 atomic percent) and high moment (Cr content < 18 atomic percent) cobalt alloys for magnetic layers in Longitudinal magnetic recording, such as, for example, Co-(5-25)Cr-(5-25)Pt-(5-20)B-(1.5-7.5)Cu or Au atomic percent and/or (1.5-7.5)X atomic percent where X = Ti, V, Y, Zr, Nb, Mo, Ru, Rh, La, Hf, Ta, W or Ir.

According to yet another embodiment, metal alloy 600 may be a cobalt (Co) based alloy for sputtering interlayers in Longitudinal magnetic recording, with a compositional range of, for example, Co-(5-30)Cr, Co-(5-30)Cr-(2-15)Ta.

According to still other embodiments of the present invention, metal alloy 600 may be a cobalt-, iron-, or nickel- based alloy for sputtering soft magnetic underlayers and APC (Anti-parallel coupled pinned layers) for perpendicular magnetic recording, with compositions such as, for example, Co-Ta-Zr, Co-Nb-Zr; Fe-Co-B, Fe-Co-Cr-B, Fe-Co-NiB, Co-Fe, Ne-Fe, and Ni-Mn in any possible elemental ratio.

According to another aspect of the present invention, metal alloy 600 may include cobalt (Co), greater than 0 and as much as about 5 atomic percent tantalum (Ta), and greater than 0 and as much as about 5 atomic percent zirconium (Zr).

According to the present exemplary embodiment, metal alloy 600 is a cobalt-based alloy, such as, for example, Co-5Ta-5Zr. According to another aspect, a metal alloy is a metal-based alloy or a metal compound.

Metal alloy 600 is withdrawn in a withdrawal direction [001] through a furnace or induction heating device in which a controllable, uniform thermal gradient is maintained across the entire melt during its directional solidification. When solidification occurs at near-equilibrium temperature conditions during directional solidification, the low temperature hexagonal close-packing (HCP) cobalt (Co) phase stabilization is favored. The relative proportion of the HCP Co phase is therefore increased with respect to the face-centered cubic (FCC) Co phase. As a consequence, the [0001] HCP direction (*i.e.,* the surface normal to the basal HCP planes) preferentially orients itself to the surface 601 of the metal alloy at an angle of about 54°. The highest pass through flux (PTF) can be achieved if the basal hexagonal texture is parallel to the magnetic lines of force 602 that occur during sputtering. Therefore, by machining the metal alloy 600 to create a target surface at 36° with respect to surface 601 of metal alloy 600 (*e.g.,* by cutting along line 603), the [0001] direction can be made normal to a target surface of a sputter target machined from metal alloy 600, thereby greatly increasing the PTF of a sputter target thus manufactured.

Table 1, below, illustrates the advantage in PTF of a sputter target according to one embodiment of the present invention when compared to a sputter target that has been solidified with vacuum induction melting and ingot casting and subsequently thermo-mechanically worked.

**Table 1**

| | Directionally Solidified Sputter Target | Thermo-Mechanically Worked Sputter Target |
|---|---|---|
| Composition | Co-5Ta-5Zr | Co-6Ta-4Zr |
| PTF | 15% | 5% |

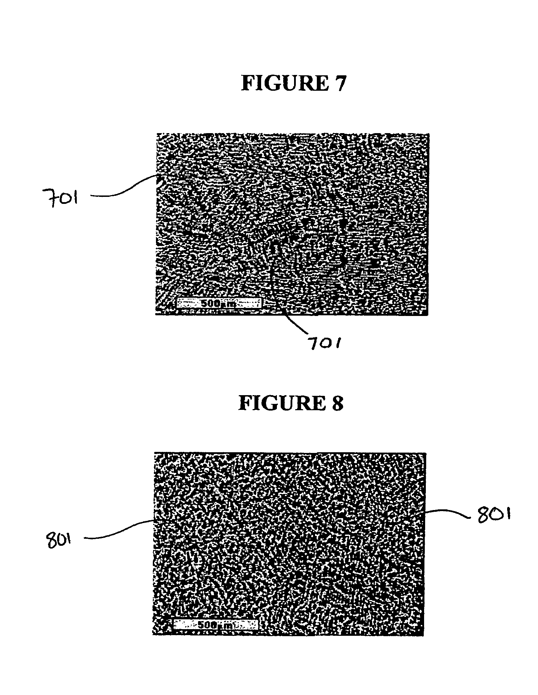

The microstructures of a target surface and of a center plane of a thermo-mechanically worked sputter target with the composition Co-6Ta-4Zr are illustrated in Figures 7 and 8, respectively. In contrast to a sputter target of the present invention, the substantial differences in the microstructure with respect to the orientation, shape and size of the solidified dendritic phases 701 and 801 are observed at a target surface (depicted in Figure 7) and at a center plane (depicted in Figure 8) of the sputter target. At the target surface, the microstructure of the primary dendritic phase (*e.g.*, the darker structures) are more columnar and thinner than at the center plane, where the primary phase microstructure is more coarse and equiaxed. In neither plane is a preferential orientation along a growth direction observed.

In comparing Figures 3 and 4, it is apparent that sizes of a substantial portion of the dendrites 205 at a target surface 101 of a sputter target 100 of the present invention are substantially similar to sizes of a substantial portion of the dendrites 206 at a center plane 105 of a sputter target 100 of the present invention. In comparing Figures 7 and 8, it is apparent that sizes of a substantial portion of the dendrites 701 at a target surface of a thermo-mechanically worked sputter target are substantially dissimilar to sizes of a substantial portion of the dendrites 801 at a center plane of a thermo-mechanically worked sputter target.

In further comparing Figures 3 and 4, it is apparent that shapes of a substantial portion of the dendrites 205 at a target surface 101 of a sputter target 100 of the present invention are substantially similar to shapes of a substantial portion of the dendrites 206 at a center plane 105 of a sputter target 100 of the present invention. In comparing Figures 7 and 8, it is apparent that shapes of a substantial portion of the dendrites 701 at a target surface of a thermo-mechanically worked sputter target are substantially dissimilar to shapes of a substantial portion of the dendrites 801 at a center plane of a thermo-mechanically worked sputter target.

According to one aspect of the present invention, the substantial portion of the dendrites at the target surface occupies an area of about 1.0 square millimeter or greater (*e.g*., a square with sides of 1.0x10⁻³ m), and the substantial portion of the dendrites at the center plane of the metal alloy occupies an area of about 1.0 square millimeter or greater (*e.g*., a square with sides of 1.0x10⁻³ m).

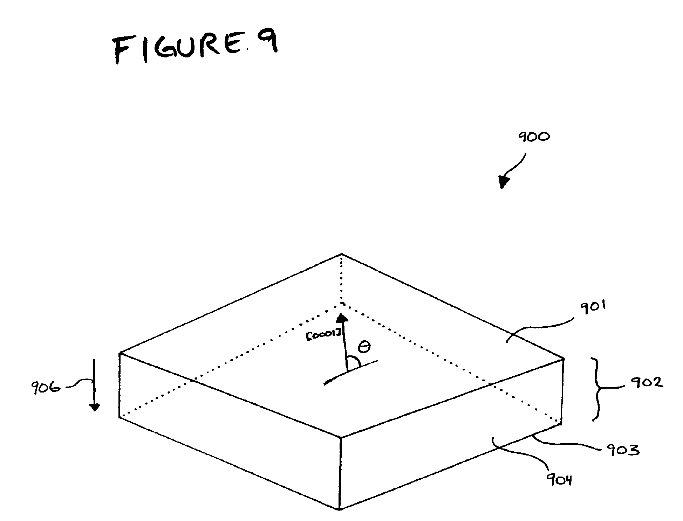

Turning now to Figure 9, a sputter target according to yet another embodiment of the present invention is illustrated. Sputter target 900 includes a metal alloy which is a cobalt (Co) based alloy. The metal alloy has a target surface such as target surface 901, a side surface such as a side surface 904 and a rear surface such as a rear surface 903. The metal alloy also has a thickness between the target surface 901 and rear surface 903, such as thickness 902. The metal alloy further has a thickness direction 906 substantially along thickness 902. Target surface 901 and rear surface 903 are outer surfaces of the metal alloy and are substantially normal to thickness direction 906. Side surface 904 is an outer surface of the metal alloy. The metal alloy further has a [0001] hexagonal close-packing (HCP) direction (*i.e,* the surface normal to the basal HCP planes) oriented at an angle θ with respect to target surface 901. According to one aspect of the present invention, the [0001] HCP direction of the metal alloy is oriented between 0° and 10° of a direction normal to the target surface 901. According to another aspect of the present invention, the [0001] HCP direction of the metal alloy is oriented substantially normal to the target surface 901.

While the sputter targets illustrated in Figures 1 and 9 have been shown with planar target surfaces and rear surfaces, it will be apparent to one skilled in the art that sputter targets within the scope of the present invention may be made in a variety of other shapes. For example, and not by way of limitation, a sputter target of the present invention may be configured as a rotatable sputter target in the form of a cylindrical solid, where the target surface and rear surface are defined as the portions of the cylinder that face towards and away from, respectively, a substrate to be coated. Alternatively, a sputter target of the present invention may be configured to have a grooved or otherwise textured target surface, or may have a non-planar target surface exhibiting smooth or stepped curvature.

While the present invention has been particularly described with reference to the various figures and embodiments, it should be understood that these are for illustration purposes only and should not be taken as limiting the scope of the invention. There may be many other ways to implement the invention. Many changes and modifications may be made to the invention, by one having ordinary skill in the art, without departing from the spirit and scope of the invention.

## Claims

1. A sputter target comprising:
a metal alloy having a target surface, a rear surface and a thickness between the target surface and the rear surface, the target surface and rear surface being outer surfaces of the metal alloy, the metal alloy having a single substantially homogenous microstructural zone across substantially the entire thickness.

2. The sputter target of claim 1, wherein the sputter target is formed by solidification at near-equilibrium temperature conditions by withdrawing the metal alloy at a first rate through a temperature gradient.

3. The sputter target of claim 1, wherein the metal alloy includes a plurality of dendrites, and substantially all of the plurality of dendrites are preferentially oriented along a growth direction.

4. The sputter target of claim 1, wherein the metal alloy includes a first plurality of dendrites oriented substantially along a first dendrite direction at the target surface, a second plurality of dendrites oriented substantially along a second direction at a center plane of the metal alloy; and the first dendrite direction being substantially parallel to the second dendrite direction.

5. The sputter target of claim 1, wherein the metal alloy includes dendrites, wherein shapes of a substantial portion of the dendrites at the target surface are substantially similar to shapes of a substantial portion of the dendrites at a center plane of the metal alloy.

6. The sputter target of claim 5, wherein the substantial portion of the dendrites at the target surface occupies an area of about 1.0 square millimeter or greater, and the substantial portion of the dendrites at the center plane of the metal alloy occupies an area of about 1.0 square millimeter or greater.

7. The sputter target of claim 1, wherein the metal alloy includes dendrites, wherein sizes of a substantial portion of the dendrites at the target surface are substantially similar to sizes of a substantial portion of the dendrites at a center plane of the metal alloy.

8. The sputter target of claim 7, wherein the substantial portion of the dendrites at the target surface occupies an area of about 1.0 square millimeter or greater, and the substantial portion of the dendrites at the center plane of the metal alloy occupies an area of about 1.0 square millimeter or greater.

9. The sputter target of claim 1, wherein the metal alloy includes cobalt (Co), greater than 0 and as much as about 5 atomic percent tantalum (Ta), and greater than 0 and as much as about 5 atomic percent zirconium (Zr).

10. The sputter target of claim 1, wherein the sputter target is for forming one or more magnetic layers on a substrate for data storage.

11. A sputter target comprising:
a metal alloy having a target surface, a rear surface and a thickness between the target surface and the rear surface, the target surface and rear surface being outer surfaces of the metal alloy,
the metal alloy having dendrites, the dendrites at the target surface oriented along substantially one direction, the dendrites at a center plane of the metal alloy oriented along substantially the same one direction.

12. The sputter target of claim 11, wherein the metal alloy is formed by directional solidification.

13. The sputter target of claim 11, wherein the metal alloy includes at least one of the following: cobalt (Co), nickel (Ni) and iron (Fe).

14. The sputter target of claim 11, wherein the metal alloy includes at least one of the following: cobalt (Co), iron (Fe), nickel (Ni), chromium (Cr), platinum (Pt), boron (B), copper (Cu), gold (Au), titanium (Ti), vanadium (V), yttrium (Y), zirconium (Zr), niobium (Nb), molybdenum (Mo), ruthenium (Ru), rhodium (Rh), lanthanum (La), hafnium (Hf), tantalum (Ta), tungsten (W) and iridium (Ir).

15. The sputter target of claim 11, wherein the metal alloy includes cobalt (Co), greater than 0 and as much as about 5 atomic percent tantalum (Ta), and greater than 0 and as much as about 5 atomic percent zirconium (Zr).

16. The sputter target of claim 11, wherein the dendrites are preferentially oriented along a growth direction.

17. The sputter target of claim 11, wherein the sputter target is for forming one or more magnetic layers on a substrate for data storage.

18. The sputter target of claim 11, wherein the metal alloy has a magnetic property.

19. A sputter target comprising:
a metal alloy which is a cobalt (Co) based alloy, the metal alloy having a target surface, a rear surface and a thickness between the target surface and the rear surface, the target surface and rear surface being outer surfaces of the metal alloy, the target surface being substantially normal to the thickness direction, a [0001] hexagonal close-packing (HCP) direction of the metal alloy oriented substantially normal to the target surface.

20. The sputter target of claim 19, wherein the sputter target is formed by directional solidification.

21. The sputter target of claim 19, wherein a pass through flux of the sputter target is greater than about 10%.

22. The sputter target of claim 19, wherein the [0001] hexagonal close-packing (HCP) direction of the metal alloy is oriented between 0° and 10° of a direction normal to the target surface.
